# EUROPEAN PATENT APPLICATION

(11) **EP 1 596 421 A2**
(43) Date of publication of application: **16.11.2005**
(21) Application number: 04076427.6
(22) Date of filing: 13.05.2004
(51) Int. Cl.: H01L 21/00, G03F 7/20

(54) **Lithographic apparatus and device manufacturing method**

(30) Priority: 09.05.2004 EP 03076498
(71) Applicant: ASML Netherlands B.V., 5504 DR Veldhoven (NL)
(72) Inventor: Hoogkamp, Jan Frederik, 4811 RZ Breda (NL); Klomp, Albert Jan Hendrik, 5623 AX Eindhoven (NL); Franssen, Johannes Hendrikus Gertrudis, 5521 GL Eersel (NL)
(74) Representative: van Westenbrugge, Andries

(57) **Abstract**

The present invention relates to a method for transferring an object (W) via a load lock (LL) between a lithography patterning chamber (PC) and a second environment. The load lock (LL) forming an inner space that is enclosed by a wall forming said inner space and the load lock (LL) comprising a first door (11) facing the lithography patterning chamber and a second door (12) facing the second environment. The load lock (LL) is at least during part of the transfer vented with a gas that is essentially free from at least one of particles, oxygen, hydrocarbon and H₂O.

## Description

The present invention relates to a lithographic projection apparatus comprising:
- a radiation system for providing a projection beam of radiation;
- a lithography patterning chamber comprising:
   - a support structure for supporting patterning means, the patterning means serving to pattern the projection beam according to a desired pattern;
   - a substrate table for holding a substrate; and
   - a projection system for projecting the patterned beam onto a target portion of the substrate; and
- a load lock for transferring an object from the lithography patterning chamber to a second environment or vice versa, the load lock defining a chamber and comprising a first door facing the lithography patterning chamber, and a second door facing the second environment, and the load lock further comprising a gas inlet for venting the load lock.

The invention further relates to a device manufacturing method.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection systems, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other table(s) is (are) being used for exposures. Dual stage lithographic apparatus are described, for example, in US 5,969,441 and WO 98/40791, both incorporated herein by reference.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

A lithographic projection apparatus usually comprises two or more different chambers, such as a handling chamber and a patterning chamber. Particularly in applications using EUV radiation, vacuum conditions are maintained in some or all of these chambers.

As a consequence objects, such as a substrate and/or a mask are brought in and removed from the lithographic projection apparatus via a load lock. A load lock is a chamber, that comprises at least two doors, where a first door typically faces vacuum conditions, having a pressure P_{vac}, and a second door typically faces atmospheric conditions, having a pressure Pₐₜₘ. When both doors are closed, the pressure in the load lock can be adjusted by pumping down or venting the load lock to a desired pressure level.

Moving, for instance, a substrate from the atmospheric environment to the vacuum environment via the load lock, usually comprises the following steps:
- opening the second door facing the atmospheric conditions Pₐₜₘ,
- delivering the substrate from atmospheric conditions Pₐₜₘ in the load lock,
- closing the second door,
- pumping down the load lock to vacuum conditions P_{vac},
- opening the first door facing the vacuum conditions P_{vac}, and
- delivering the substrate from the load lock to the vacuum conditions P_{vac}.

The movement of a substrate in the opposite direction, i.e. from the vacuum conditions to the atmospheric conditions, usually comprises the following steps:
- opening the first door facing the vacuum conditions P_{vac},
- delivering the substrate from the vacuum conditions P_{vac} into the load lock,
- closing the first door,
- venting the load lock to atmospheric conditions Pₐₜₘ,
- opening the second door facing the atmospheric conditions Pₐₜₘ, and
- delivering the substrate from the load lock to the atmospheric conditions Pₐₜₘ.

Of course, more than one substrate can be moved at the same time.

However, the use of such a load lock can have a few disadvantages. For instance, pumping down the load lock is preferably done as quickly as possible, in order to achieve a high throughput. As a result, the temperature of the gas in the load lock may drop (adiabatic process). The gasses in the load lock may contain water, which condenses as a result of the temperature drop. The condensation nuclei are particles that can drop on the substrate that is transported to the vacuum conditions. These particles contaminate the substrate and subsequently, for example, the substrate handling chamber and the exposure chamber.

Also, when the load lock comprises a gas, that contains water, the water molecules tend to stick to the walls of the load lock due to adhesive forces. This has a negative impact on the pumping down time of the load lock.

Furthermore, when the door facing the vacuum conditions is opened, the content of the load lock (gasses) can migrate from the load lock to the vacuum space, such as the wafer handling chamber and the exposure chamber. If this space contains oxygen and/or hydrocarbons and/or H₂O, this can result, in combination with EUV radiation, in degradation of the process related components, such as contaminated optics. If the volume in the load lock comprises particles, these particles can contaminate the substrates being transported by the load lock as well process related components.

Finally, substrates being transported, can absorb or chemically bond with oxygen, hydrocarbons and/or H₂O. When the substrate is in a vacuum, the substrate might gas out, also causing degradation of the process related components.

It is an object of the present invention to provide an improved lithographic projection apparatus which does not exhibit above mentioned disadvantages. This and other objects are achieved according to the invention in a lithographic projection apparatus, characterized in that the gas inlet is connected to a gas supply that supplies, at least during part of the transfer of the object a gas to the gas inlet, the gas being essentially free from at least one of particles, oxygen, hydrocarbon and H₂O.

Venting the load lock with such a gas, reduces the migration of hazardous particles into the load lock, and also reduces molecular contamination, for instance by oxygen, hydrocarbon and H₂O, in the load lock. The absence of these particles and/or molecules has a positive effect on the pump down time of the load lock. Also, the further migration of these particles and/or molecules to the inside of the lithographic projection apparatus can be limited.

In a further embodiment of the present invention, the lithography patterning chamber has a first pressure and the second environment has a second pressure, the first pressure being lower than the second pressure. Load locks are advantageously used for transferring objects between a first pressure and a second pressure.

When the load lock is brought back from the first to the second pressure, this can advantageously be done with a gas as defined above.

In a further embodiment of the present invention, the load lock is vented to a third pressure that is higher than the second pressure. Such an overpressure will limit the migration of hazardous gas particles from the environment into the load lock and also reduces the molecular contamination.

In a further embodiment of the present invention, the load lock is vented when the second door is open. This will even further reduce the migration of hazardous particles and contaminating molecules to the load lock. Such continued venting creates a flow out of the load lock to the environment, reducing the migration of hazardous gas particles and contaminating molecules from the environment into the load lock.

In a further embodiment of the present invention, the object is selected from a group of objects used in a lithographic projection apparatus, including a mask or a wafer. The transportation of an object between a lithography patterning chamber and a second environment, having different pressure, via a load lock, is often done in lithographic projection apparatus. Also the amount of particle and molecular contamination needs to be minimized in such apparatus, so the method presented here can advantageously be used in such apparatus.

In a further embodiment of the present invention, the gas is one of N₂ gas, Ar gas and synthetic air. These gasses are free from contaminating particles and are also free from contaminating molecules, such as hydrocarbon and H₂O. These gasses are also readily available.

In a further embodiment of the present invention, a gas outlet is connected to the gas supply. This makes it possible to re-use the gas that is essentially free from oxygen and/or hydrocarbon and/or H₂O. Preferably, the gas outlet is connected to the gas supply via a filter system.

According to a further aspect, the present invention relates to a device manufacturing method comprising:
- providing a substrate that is at least partially covered by a layer of radiation-sensitive material in a lithography patterning chamber;
- providing a projection beam of radiation using a radiation system;
- using patterning means to endow the projection beam with a pattern in its cross-section; and
- projecting the patterned beam of radiation onto a target portion of the layer of radiation-sensitive material,
- transferring the substrate from and to said lithography patterning chamber via a load lock, the load lock defining a chamber and comprising a first door facing the lithography patterning chamber and a second door facing a second environment,
characterized by
venting the load lock with a gas that is essentially free from at least one of particles, oxygen, hydrocarbon and H₂O at least during part of the transfer.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

Embodiments of the invention will now be described, by way of example only, with reference to the accompanying schematic drawings in which corresponding reference symbols indicate corresponding parts, and in which:
- Figure 1 depicts a lithographic projection apparatus according to an embodiment of the invention;
- Figure 2 schematically depicts a load lock according to an embodiment of the present invention; and
- Figure 3a and 3b depict a graph of the pressure in the load lock with respect to the time, according to an embodiment of the present invention.

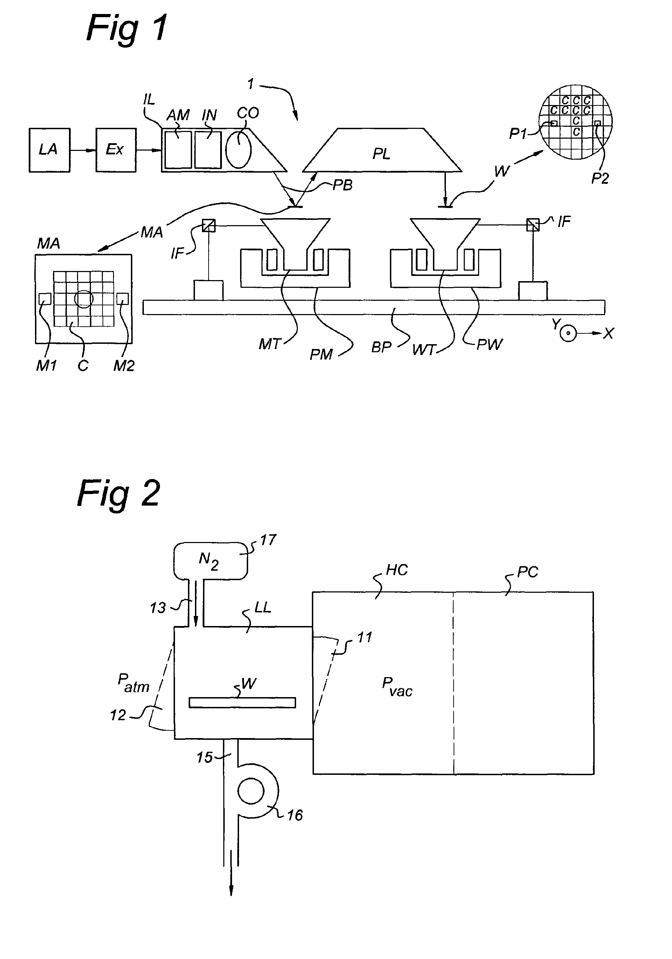

Figure 1 schematically depicts a lithographic projection apparatus 1 according to a particular embodiment of the invention. The apparatus comprises:
- a radiation system Ex, IL, for supplying a projection beam PB of radiation (e.g. EUV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. mirrors for EUV radiation) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example with a transmissive mask. Alternatively, the apparatus may employ another kind of patterning means, such as a programmable mirror array of a type as referred to above.

The source LA (e.g. EUV source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Fig. 2 schematically depicts a load lock LL according to an embodiment of the present invention. The load lock LL comprises two doors 11, 12. The first door 11 faces the inside of the lithographic projection apparatus 1, comprising the handling chamber HC and the lithography patterning chamber PC, in which vacuum conditions, having a pressure P_{vac}, are maintained. The second door 12 faces atmospheric conditions, having a pressure that is, for instance, equal to atmospheric pressure Pₐₜₘ. However, the invention can also advantageously be applied for other pressure values.

The load lock LL comprises a wall that forms an inner space. The load lock LL is further provided with supporting means (not shown) for supporting one or more objects, such as substrates, as will be known to a person skilled in the art.

As can be seen in Fig. 2, the load lock LL is also provided with a gas inlet 13 and a gas outlet 15. The gas outlet 15 can be provided with a pump 16 to pump down the load lock LL to vacuum conditions of, for instance, 10⁻³ - 10⁻⁵ Pa, a pressure substantially equal to or lower than P_{vac}. The movement of, for instance, a substrate W from the atmospheric environment to the vacuum via the load lock LL, usually comprises the following steps:
- opening the second door 12 facing the atmospheric conditions Pₐₜₘ,
- transferring the substrate W from atmospheric conditions Pₐₜₘ into the load lock LL,
- closing the second door 12,
- pumping down the load lock LL to a pressure substantially equal to or less than vacuum conditions P_{vac} through gas outlet 15 using pump 16,
- opening the first door 11 facing the vacuum conditions P_{vac}, and
- transferring the substrate W to the vacuum conditions P_{vac} from the load lock LL.

The gas inlet 13 can be used to vent the load lock in order to raise the pressure in the load lock from P_{vac} to Pₐₜₘ. Movement of a substrate W from the vacuum to the atmospheric environment via the load lock LL, usually comprises the following steps:
- pumping down the load lock LL to a pressure substantially equal to or less than the vacuum conditions P_{vac},
- opening the first door 11 facing the vacuum conditions P_{vac},
- transferring the substrate W from the vacuum conditions P_{vac} into the load lock LL,
- closing the first door 11,
- venting the load lock LL to a pressure substantially equal to or more than atmospheric conditions Pₐₜₘ via the gas inlet 13,
- opening the second door 12 facing the atmospheric conditions Pₐₜₘ, and
- delivering the substrate W to the atmospheric conditions Pₐₜₘ.

Accordingly, hazardous particles and contaminating molecules, such as oxygen, hydrocarbons and/or H₂O, are limited from entering the load lock LL by filling the load lock LL with a specially chosen gas that doesn't comprise these particles or molecules. Gasses, such as N₂ gas, Ar gas or synthetic air, but of course also other suitable gasses, can be used, as will be understood by a person skilled in the art.

When the load lock LL is brought back from P_{vac} to Pₐₜₘ by supplying gas through gas inlet 13 to the load lock LL a special gas is typically used instead of normal environmental air. Fig. 2 shows a gas supply 17 comprising N₂ gas. Gas supply 17 may be a high pressure tank.

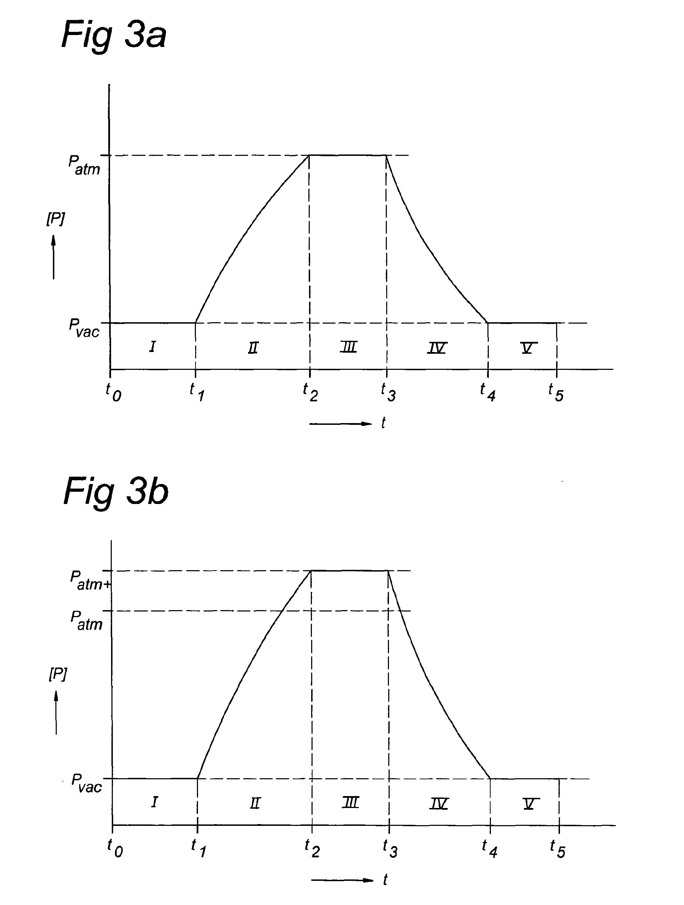

Figure 3a shows a graph of the pressure P in the load lock LL with respect to time t, during a pumping and venting cycle of the load lock LL, in which, e.g. wafers W can be exchanged between the first and second environment. The graph is divided into five segments I, II, III, IV and V.

During phase I, from to to t₁, the pressure in the load lock LL is substantially equal to or less than P_{vac}. During this phase, the first door 11 facing the vacuum conditions can be opened to transfer substrate W, or the like, to or from the load lock LL. At time t₁ the first door 11 is closed. During phase II, from t₁ to t₂, the pressure in the load lock LL is brought back to substantially Pₐₜₘ, by venting the load lock LL via the gas inlet 13 with a suitable gas. In this embodiment, the load lock LL is vented with N₂ gas. Gas inlet 13 is connected to the gas supply 17. At time t₂, the load lock is at substantially atmospheric pressure and filled with N₂ gas and the second door 12 facing the atmospheric conditions can be opened. During phase III, from time t₂ to t₃, the substrate W or the like can be transferred to or from the load lock LL.

Since the load lock LL is filled with N₂ gas almost no hazardous particles or contaminating molecules will enter the load lock during phase III, when the second door 12 is opened. However, some particles and/or molecules may migrate into the load lock LL.

Therefore, according to a further embodiment of the present invention, an overpressure Pₐₜₘ₊ is established in the load lock LL during phase III, as can be seen in Fig. 3b. This overpressure Pₐₜₘ₊ can be realized by continuing the inflow of N₂ gas through gas inlet 13 during phase III, even when the second door 12 is open. The overpressure will cause a gas flow from the load lock LL to the atmospheric environment, minimizing the migration of particles and/or molecules from the atmospheric environment to the load lock LL.

At time t₃, the second door 12 is closed and during phase IV, the load lock LL is pumped down to substantially equal to or less than P_{vac} via gas outlet 15 by pump 16. The gas that is pumped down from the load lock LL is substantially the gas that was supplied to the load lock LL, namely the N₂ gas. In a preferred embodiment, the gas outlet 15 can be connected to the gas supply 17, for instance via a filter system (not shown), to re-use the N₂ gas.

Whilst specific embodiments of the invention have been described above, it will be appreciated that the invention may be practiced otherwise than as described. The description is not intended to limit the invention. For instance, it will be understood that the invention also applies to a method of transferring an object between a first and a second environment, where the first and second environments substantially have the same pressure.

## Claims

1. A lithographic projection apparatus comprising:
- a radiation system for providing a projection beam (PB) of radiation;
- a lithography patterning chamber (PC) comprising
• a support structure (MT) for supporting patterning means (MA), the patterning means (MA) serving to pattern the projection beam (PB) according to a desired pattern;
• a substrate table (WT) for holding a substrate (W); and
• a projection system (PL) for projecting the patterned beam onto a target portion (C) of the substrate (W); and
- a load lock (LL) for transferring an object (MA, W) from the lithography patterning chamber (PC) to a second environment or vice versa, the load lock defining a chamber and comprising a first door (11) facing the lithography patterning chamber (PC), and a second door (12) facing the second environment, and the load lock (LL) further comprising a gas inlet (13) for venting the load lock (LL),
**characterized in that**
the gas inlet (13) is connected to a gas supply (17) that supplies, at least during part of the transfer of the object a gas to the gas inlet (13), the gas being essentially free from at least one of particles, oxygen, hydrocarbon and H₂O.

2. A lithographic projection apparatus according to claim 1, wherein the lithography patterning chamber (PC) has a first pressure (P_{vac}) and the second environment has a second pressure (Pₐₜₘ), the first pressure (P_{vac}) being lower than the second pressure (Pₐₜₘ).

3. A lithographic projection apparatus according to claim 1 or 2, wherein the load lock (LL) further comprises a gas outlet (15) connected to a pump (16) that pumps gas out of the load lock (LL) via the gas outlet (15).

4. A lithographic projection apparatus according to claim 3, wherein the gas outlet (15) is connected to the gas supply (17).

5. A lithographic projection apparatus according to any of the claims 1 - 4, wherein the load lock (LL) is vented to a third pressure (Pₐₜₘ₊) that is higher than the second pressure (Pₐₜₘ).

6. A lithographic projection apparatus according to any of the preceding claims, wherein the load lock (LL) is vented when the second door (12) is open.

7. A lithographic projection apparatus according to any of the preceding claims, wherein the gas is one of N₂ gas, Ar gas and synthetic air.

8. A device manufacturing method comprising:
- providing a substrate (W) that is at least partially covered by a layer of radiation-sensitive material in a lithography patterning chamber (PC);
- providing a projection beam (PB) of radiation using a radiation system;
- using patterning means (MA) to endow the projection beam (PB) with a pattern in its cross-section;
- projecting the patterned beam of radiation onto a target portion (C) of the layer of radiation-sensitive material; and
- transferring the substrate (W) from and to said lithography patterning chamber (PC) via a load lock (LL), the load lock (LL) defining a chamber and comprising a first door (11) facing the lithography patterning chamber (PC) and a second door (12) facing a second environment,
**characterized by**
venting the load lock (LL) with a gas that is essentially free from at least one of particles, oxygen, hydrocarbon and H₂O at least during part of the transfer.

9. Method according to claim 8, wherein the lithography patterning chamber (PC) has a first pressure (P_{vac}) and the second environment has a second pressure (Pₐₜₘ), the first pressure (P_{vac}) being lower than the second pressure (Pₐₜₘ).

10. Method according to claim 9, wherein a transfer from the lithography patterning chamber (PC) to the second environment comprises:
- pumping down the load lock (LL) to substantially equal to or less than the first pressure (P_{vac}),
- opening the first door (11),
- transferring the object (W) from the lithography patterning chamber (PC) into the load lock (LL),
- closing the first door (11),
- venting the load lock (LL) with a gas that is essentially free from at least one of particles, oxygen, hydrocarbon and H₂O to substantially equal or to more than the second pressure (Pₐₜₘ),
- opening the second door (12)
- transferring the object (W) to the second environment.

11. Method according to any of claims 8-10, wherein the load lock (LL) is vented to a third pressure (Pₐₜₘ₊) that is higher than the second pressure (Pₐₜₘ).

12. Method according to any of claims 8-11, wherein the load lock (LL) is vented when the second door (12) is open.

13. Method according to any of claims 8 -12, wherein the object is at least one of a mask (MA) or a wafer (W).

14. Method according to any of claims 8-13, where the gas is one of N₂ gas, Ar gas and synthetic air.

15. A device manufacturing method comprising:
- providing a substrate (W) that is at least partially covered by a layer of radiation-sensitive material in a lithography patterning chamber (PC);
- providing a projection beam (PB) of radiation using a radiation system;
- using patterning means (MA) to endow the projection beam (PB) with a pattern in its cross-section;
- projecting the patterned beam of radiation onto a target portion (C) of the layer of radiation-sensitive material; and
- transferring an object from and to said lithography patterning chamber (PC) via a load lock (LL), the load lock (LL) defining a chamber and comprising a first door (11) facing the lithography patterning chamber (PC) and a second door (12) facing a second environment, the object being one of said substrate (W) and said patterning means (MA),
**characterized by**
venting the load lock (LL) with a gas that is essentially free from at least one of particles, oxygen, hydrocarbon and H₂O at least during part of the transfer.
